# EUROPEAN PATENT APPLICATION

(11) **EP 4 793 672 A1**
(43) Date of publication of application: **19.08.2026**
(21) Application number: 24877583.5
(22) Date of filing: 14.10.2024
(51) Int. Cl.: G01T 1/24, H10F 30/00, H10F 77/20, H10F 77/12, H10F 10/17

(54) **X-RAY DETECTOR**

(30) Priority: 13.10.2023 US 202363590085 P; 01.11.2023 KR 20230149159
(71) Applicant: Rayence Co., Ltd., Hwaseong-si, Gyeonggi-do 18449 (KR); Vatech Ewoo Holdings Co., Ltd., Hwaseong-si, Gyeonggi-do 18449 (KR); Qpix solutions Inc., Morrisville, NC 27560 (US)
(72) Inventor: KIM, Ji Uk, Hwaseong-si, Gyeonggi-do 18449 (KR); YUN, Seung Man, Morrisville, North Carolina 27560 (US)
(74) Representative: Lorenz & Kollegen
(86) International application number: PCT/KR2024/015523
(87) International publication number: WO 2025/080048

(57) **Abstract**

The present invention provides an X-ray detector having a driving sequence in which a standby period, a ready period, an accumulation period, and a readout period are repeated. The X-ray detector comprises: a first electrode on a substrate, to which a pixel voltage is applied; a photoelectric material layer on the first electrode; and a second electrode on the photoelectric material layer, wherein a switching voltage less than or equal to a potential of the pixel voltage is applied to the second electrode during at least a partial period of the standby period, and a bias voltage is applied between the standby period and a next standby period.

## Description

### Technical Field

The present disclosure relates to an X-ray detector.

### Background Art

In recent years, digital detectors have become widely used for X-ray imaging.

X-ray detectors are divided into indirect-conversion and direct-conversion types. Indirect-conversion detectors have a scintillator that first converts X-rays into visible light, and then the visible light is converted to electrical signals. Direct-conversion detectors, on the other hand, use a photoconductor that absorbs X-rays and directly creates electrical signals.

In direct conversion, a bias voltage is applied to an upper electrode disposed on top of a photoconductor layer, and the bias voltage is maintained at a constant level higher than a pixel voltage applied to a lower electrode disposed below the photoconductor layer.

Accordingly, polarization occurs in the photoconductor layer and charges are trapped. If the polarization persists for a long time and becomes fixed, it may cause a decrease in the sensitivity of X-ray detection.

### Disclosure

### Technical problem

Accordingly, the present disclosure has been made keeping in mind the above problems occurring in the related art, and the present disclosure is intended to provide a method to mitigate polarization in X-ray detectors.

### Technical Solution

In order to achieve the above objective, according to an aspect of the present disclosure, there is provided an X-ray detector with a driving sequence that repeats a standby section, a ready section, an integration section, and a readout section, the X-ray detector including: a first electrode, on a substrate, to which a pixel voltage is applied; a photoconductor layer on the first electrode; and a second first electrode on the photoconductor layer, wherein a switching voltage having a potential less than or equal to a potential of the pixel voltage may be applied to the second electrode during at least a portion of the standby section, and a bias voltage may be applied to the second electrode between the standby section and a next standby section.

During at least a portion of the standby section, the switching voltage having a same potential as the pixel voltage may be applied to the second electrode.

During at least a portion of the standby section, the switching voltage having a potential lower than that of the pixel voltage may be applied to the second electrode.

The standby section may include a first period and a second period, wherein during the first period, the switching voltage having a potential lower than that of the pixel voltage may be applied to the second electrode, and from the second period after the first period to the next standby section, the bias voltage may be applied to the second electrode.

The standby section may include a first period and a second period, wherein during the first period, a first switching voltage may be applied to the second electrode, and during the second period after the first period, a second switching voltage may be applied to the second electrode, wherein one of the first and second switching voltages may have a same potential as the pixel voltage, and remaining one of the first and second switching voltages may have a potential lower than that of the pixel voltage.

During the standby section, first and second switching voltages may be alternately and repeatedly applied to the second electrode, wherein one of the first and second switching voltages may have a same potential as the pixel voltage, and remaining one of the first and second switching voltages may have a potential lower than that of the pixel voltage.

The photoconductor layer may be made of a ferroelectric material.

The ferroelectric material may be perovskite.

A potential of the bias voltage may be 0.01 to 0.1 V per thickness (µm) of the photoconductor layer (i.e., 0.01 to 0.1 V/µm).

A potential of the bias voltage may be 1.5 to 20 V.

### Advantageous Effects

According to the present disclosure, a switching voltage lower than a pixel voltage to a second electrode, which is an upper electrode, during at least a portion of the standby period in the driving sequence of an X-ray detector, and afterwards, a bias voltage higher than the pixel voltage is applied to the second electrode.

Therefore, charge trapping can be alleviated by reducing residual charges and mitigating polarization in a photoconductor layer.

### BRIEF DESCRIPTION OF THE DRAWINGS

The above and other objectives, features, and other advantages of the present disclosure will be more clearly understood from the following detailed description when taken in conjunction with the accompanying drawings, in which:
FIG. 1 is a schematic view of an X-ray detector according to a first embodiment of the present disclosure;
FIG. 2 is a cross-sectional view schematically showing a sensor panel according to the first embodiment of the present disclosure;
FIG. 3 is a view schematically showing the timing of switching voltage and bias voltage according to the first embodiment of the present disclosure;
FIG. 4 is a view schematically showing the timing of switching voltage and bias voltage according to a second embodiment of the present disclosure; and
FIG. 5 is a view schematically showing the timing of switching voltage and bias voltage according to a third embodiment of the present disclosure.

### DETAILED DESCRIPTION

Hereinafter, embodiments of the present disclosure will be described in detail with reference to the drawings.

### <First Embodiment>

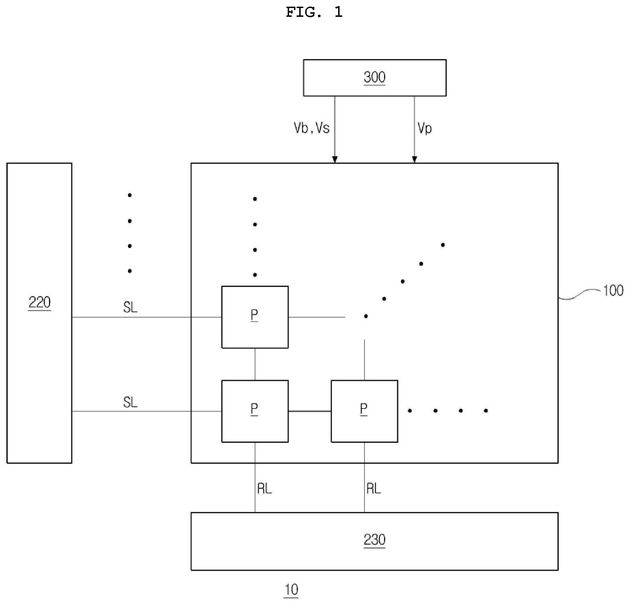

FIG. 1 is a schematic view of an X-ray detector according to a first embodiment of the present disclosure.

Referring to FIG. 1, an X-ray detector 10 according to a first embodiment of the present disclosure corresponds to a direct-conversion X-ray detector provided with a photoconductor layer.

The X-ray detector 10 may include a sensor panel 100, a driving circuit part for driving the sensor panel 100, and a power circuit 300 that supplies a driving voltage (or power voltage) to drive the X-ray detector 10.

The sensor panel 100 may be a direct-conversion sensor panel 100 that directly converts incident X-rays into electrical signals.

Although not specifically shown, the sensor panel 100 may include: an active area, which is the area that actually receives and detects X-rays; and a non-active area located outside the active area.

In the active area, a pixel array composed of a plurality of pixels P is disposed on a substrate, and the pixels P may be arranged in a matrix form along a plurality of row lines and a plurality of column lines.

On the substrate of the sensor panel 100, a plurality of scan lines (or gate lines) SL extending along the row lines and a plurality of readout lines (or data lines) RL extending along the column lines may be disposed. The scan lines SL and the readout lines RL may be connected to corresponding pixels P.

Each pixel P may be provided with a photoconductive element that detects X-rays and generates a corresponding electrical signal.

The driving circuit part for driving the sensor panel 100 may include a scan circuit 220 and a readout circuit 230.

In this case, the scan circuit 220 sequentially scans the scan lines SL and applies a scan signal of a turn-on level. Accordingly, individual row line is sequentially selected, and data, which is an electrical signal stored in the pixel P located in the selected row line, may be output to the corresponding readout line RL. Then, the readout circuit 230 may receive the data stored in the pixel P through the readout line RL.

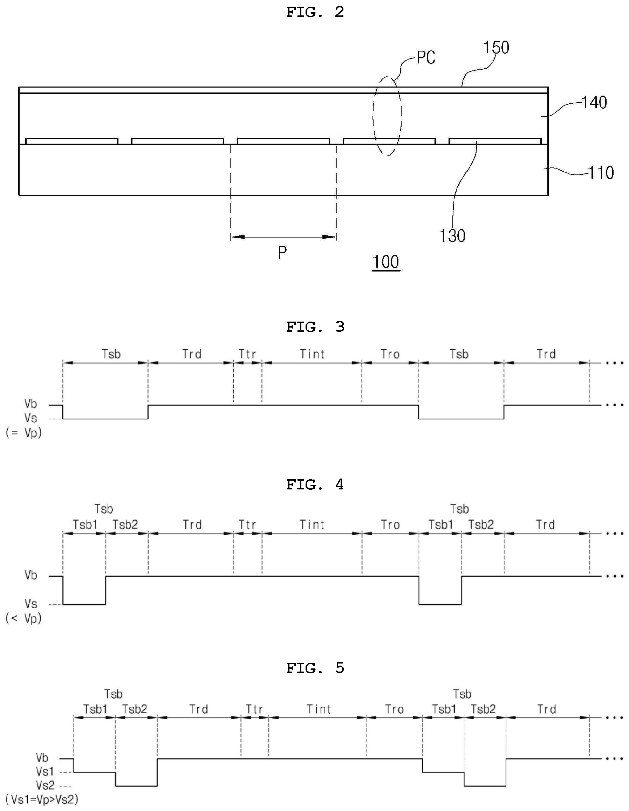

Meanwhile, the sensor panel 100 including the pixel p on which the photoconductive element is formed will be described with further reference to FIG. 2. FIG. 2 is a cross-sectional view schematically showing a sensor panel according to the first embodiment of the present disclosure.

The sensor panel 100 may include the photoconductive element PC formed in each pixel P on the substrate 110.

In this case, the substrate 110 may be composed of, but is not limited to, a CMOS substrate, a glass substrate, or a plastic substrate having flexible properties.

The photoconductive element PC provided in each pixel P may include: a first electrode (or pixel electrode) 130, which is a lower electrode provided on the substrate 110; a second electrode (or common electrode) 150, which is an upper electrode located above the first electrode 130; and the photoconductor layer 140 interposed between the first electrode 130 and the second electrode 150.

The first electrode 130 may be provided in a patterned form on a pixel-by-pixel basis corresponding to each pixel P.

The photoconductor layer 140 provided on the first electrode 130 may be formed, for example, continuously along the pixels P substantially arranged in the active area. In other words, the photoconductor layer 140 may be formed corresponding to the pixels P arranged in the active area.

As a photoconductor forming the photoconductor layer 140a, a ferroelectric material such as perovskite, for example, may be used, but is not limited thereto.

In this case, the perovskite is a material with a crystal structure following the formula ABX3, where A denotes a monovalent cation, B denotes a metal cation, and X may denote a halogen anion.

The perovskite may be, but is not limited to, CsPbBr3, Cs2AgBiBr6, MAPbI3, or MAPbBr3.

The photoconductor layer 140 of perovskite may be formed, for example, by a solution method of applying and curing a solution containing a perovskite powder, but is not limited thereto. As an example of the solution method, the photoconductor layer 140 of perovskite may be formed through a process of applying and curing a solution (or paste) containing a perovskite powder and a solvent onto the substrate 110 on which the first electrode 130 is provided.

The second electrode 150 provided on the photoconductor layer 140 may be formed, for example, continuously along the pixels P substantially arranged in the active area. In other words, the second electrode 150 may be formed corresponding to the pixels P arranged in the active area.

In order to implement charge generation due to photoelectric action in the photoconductive element PC configured as above, a pixel voltage Vp, which is a driving voltage (or first driving voltage), may be applied to the first electrode 130, and a bias voltage Vb, which is a driving voltage (or second driving voltage), may be applied to the second electrode 150. Accordingly, a difference voltage between the bias voltage Vb and the pixel voltage Vp is applied to the photoconductive element PC, and in this state, when X-rays are incident, corresponding charges are generated by photoelectric action, and the generated charges may be collected at the first electrode 130.

The driving voltage may be generated and provided by the power circuit 300. In this regard, the power circuit 300 may generate the pixel voltage Vp and the bias voltage Vb and output the pixel voltage Vp and the bias voltage Vb to the sensor panel 100.

At this time, in the embodiment, an example is given where the bias voltage Vb has a higher potential than the pixel voltage Vp. For example, the pixel voltage Vp may be a ground voltage or a voltage of positive potential (e.g., 1.2 to 2.2 V), and in the case of the photoconductor layer 140 of perovskite, the bias voltage Vb may be a voltage of positive potential higher than the pixel voltage Vp (e.g., 1.5 to 20 V).

In this regard, the perovskite has a short carrier lifetime, enabling stable operation even at lower driving voltages compared to photoconductors such as a-Se and CdTe, and thus the bias voltage Vb may have a value of 0.01 to 0.1 V per (µm) of the photoconductor layer 140 of perovskite, that is, 0.01 to 0.1 V/µ m.

Meanwhile, in the embodiment, in order to alleviate charge trapping due to polarization in the photoconductor layer 140, a switching voltage Vs, which is a driving voltage of a potential different from the bias voltage Vb, may be applied to the second electrode 150.

To this end, the power circuit 300 may generate the switching voltage Vs and provide the generated switching voltage Vs to the sensor panel 100.

At this time, in the embodiment, the switching voltage Vs may have the same potential as the pixel voltage Vp.

The switching voltage Vs may be applied to the second electrode 150 for a certain period of time before X-ray irradiation, for example. After the switching voltage Vs is applied, the bias voltage Vb may be continuously applied to the second electrode 150.

In this way, by applying the switching voltage Vs at a level lower than the bias voltage Vb to the second electrode 150, polarization in the photoconductor layer 140 may be mitigated, thereby alleviating charge trapping.

The above switching voltage Vs application operation will be described with reference to FIG. 3. FIG. 3 is a view schematically showing the timing of switching voltage and bias voltage according to the first embodiment of the present disclosure.

Referring to FIG. 3 along with FIGS. 1 and 2, the driving sequence of the X-ray detector 10 may include, for example, a standby section Tsb, a ready section Trd, a trigger section Ttr, an integration section Tint, and a readout section Tro, and this series of sections may be repeated.

At this time, the switching voltage Vs may be applied, for example, to the second electrode 150 throughout the standby section Tsb. That is, after the readout period Tro of the previous frame ends, the switching voltage Vs may be applied to the second electrode 150 during the standby section Tsb.

Accordingly, during the standby section Tsb, the pixel voltage Vp is applied to the first electrode 130 of the photoconductor element PC, and the switching voltage Vs of the same potential as the pixel voltage Vp is applied to the second electrode 150.

In this case, the voltage difference between the first and second electrodes 130 and 150 becomes 0 V in the photoconductor element PC, so that the forward polarization when the bias voltage Vb is applied may be mitigated. In addition, since voltages of the same potential are applied to the first and second electrodes 130 and 150, the problem of reverse polarization does not occur.

Meanwhile, when the ready section Trd starts by a ready signal after the standby section Tsb ends, the output of the switching voltage Vs is terminated and the bias voltage Vb is applied to the second electrode 150. The bias voltage Vb may be continuously and consistently applied to the second electrode 150 during the ready section Trd, the trigger section Ttr, the integration section Tint, and the readout section Tro.

When the next standby section Tsb starts after the readout section Tro ends, the output of the bias voltage Vb is terminated and the switching voltage Vs is applied to the second electrode 150.

As previously mentioned, in the embodiment, after the bias voltage Vb is consistently applied, the switching voltage Vs of a potential lower than that of the bias voltage Vb and the same as that of the pixel voltage Vp is applied to the second electrode 150 during the standby period Tsb, and then the bias voltage Vb is applied to the second electrode 150.

As a result, charge trapping may be alleviated by reducing residual charges and mitigating polarization in the photoconductor layer 140.

### <Second Embodiment>

FIG. 4 is a view schematically showing the timing of switching voltage and bias voltage according to a second embodiment of the present disclosure.

In the embodiment, detailed description of the same and similar configuration as the above-described first embodiment may be omitted.

An X-ray detector of the second embodiment may have the same or similar configuration as the X-ray detector of the first embodiment described above.

Meanwhile, in the embodiment, the switching voltage Vs applied to mitigate polarization in the photoconductor layer (140 in FIG. 2) may have a potential lower than that of the pixel voltage Vp.

In addition, the switching voltage Vs may be applied, for example, during a portion of the standby section Tsb.

In this regard, referring to FIG. 4, during a portion of the standby section Tsb, for example, a first period Tsbl, which is the initial period, the switching voltage Vs at a level lower than the pixel voltage Vp may be applied to the second electrode (150 in FIG. 2).

Next, after the first period Tsbl ends, the bias voltage Vb may be continuously applied to the second electrode from a second period Tsb2, which is the remaining period of the standby section Tsb.

In other words, the bias voltage Vb may be continuously and consistently applied to the second electrode 150 during the second period Tsb2 of the standby section Tsb, the ready section Trd, the trigger section Ttr, the integration section Tint, and the readout section Tro.

Next, When the next standby section Tsb starts after the readout section Tro ends, the switching voltage Vs is applied to the second electrode during a first period Tsbl of this next standby section Tsb.

As described above, in the embodiment, the switching voltage Vs has a lower potential than the pixel voltage Vp, and may therefore be configured to be applied to the second electrode during a portion Tsbl of the standby section Tsb.

Regarding this, since the switching voltage Vs has a lower level than the pixel voltage Vp, if such switching voltage Vs is applied for a long time, reverse polarization may occur. In terms of preventing the reverse polarization, in the embodiment, the switching voltage Vs is applied to the second electrode during a portion Tsbl of the standby section Tsb.

In addition, by applying the switching voltage Vs of a lower level than the pixel voltage Vp, polarization in the photoconductor layer 140 is mitigated, thereby alleviating charge trapping.

Meanwhile, in the embodiment, the voltages applied to the second electrode in the first period Tsbl and the second period Tsb2 may have an order opposite to the above. In this regard, the bias voltage Vb may be applied to the second electrode during the first period Tsbl of the standby period Tsb, whereas a second switching voltage Vs2 at a level lower than the pixel voltage Vp may be applied to the second electrode during the second period Tsb2 of the standby period Tsb, and the bias voltage Vb may be applied to the second electrode during the ready section Trd, the trigger section Ttr, the integration section Tint, and the readout section Tro.

### <Third Embodiment>

FIG. 5 is a view schematically showing the timing of switching voltage and bias voltage according to a third embodiment of the present disclosure.

In the embodiment, detailed description of the same and similar configuration as the above-described first and second embodiments may be omitted.

An X-ray detector of the third embodiment may have the same or similar configuration as the X-ray detector of the first embodiment described above.

Meanwhile, in the embodiment, in order to mitigate polarization in the photoconductor layer (140 in FIG. 2), a plurality of switching voltages Vs1 and Vs2 with potentials lower than that of the pixel voltage Vp may be used.

In addition, the plurality of switching voltages Vs1 and Vs2 may be applied at different periods, for example, during the standby section Tsb.

Regarding this, in the embodiment, an example is given where a first switching voltage Vsl having the same potential as the pixel voltage Vp and a second switching voltage Vs2 having a lower potential than the pixel voltage Vp are used.

In addition, the first and second switching voltages Vs1 and Vs2 may be applied during the standby section Tsb.

Regarding this, referring to FIG. 5, during a portion of the standby section Tsb, for example, a first period Tsbl, which is the initial period, the first switching voltage Vsl at the same level as the pixel voltage Vp may be applied to the second electrode (150 in FIG. 2).

Next, after the first period Tsbl ends, the second switching voltage Vs2 at a lower level than the pixel voltage Vp may be applied to the second electrode during a second period Tsb2, which is the remaining period of the standby section Tsb.

Next, after standby section Tsb ends, the bias voltage Vb may be continuously applied to the second electrode from the ready section Trd.

In other words, the bias voltage Vb may be continuously and consistently applied to the second electrode during the ready section Trd, the trigger section Ttr, the integration section Tint, and the readout section Tro.

Next, When the next standby section Tsb starts after the readout section Tro ends, the first switching voltage Vsl may be applied again to the second electrode during a first period Tsbl of this next standby section Tsb, and afterwards, the second switching voltage Vs2 may be applied to the second electrode during a second period Tsb2.

Meanwhile, in the embodiment, the first and second switching voltages Vsl and Vs2 may be applied in an order opposite to the above. In this regard, the second switching voltage Vs2 at a lower level than the pixel voltage Vp may be applied to the second electrode during the first period Tsbl of the standby section Tsb, and afterwards, the first switching voltage Vsl at the same level as the pixel voltage Vp may be applied to the second electrode during the second period Tsb2.

As another example, the first and second switching voltages Vsl and Vs2 may be applied alternately within the standby section Tsb. For example, the first switching voltage Vsl (or the second switching voltage Vs2) is applied, and then the second switching voltage Vs2 (or the first switching voltage Vsl) is applied, and this application operation may be repeated multiple times.

As described above, in the embodiment, the plurality of switching voltages Vs1 and Vs2 below the potential of the pixel voltage Vp may be applied. As a result, while preventing the occurrence of reverse polarization in the photoconductor layer, polarization in the photoconductor layer may be further mitigated to further alleviate charge trapping.

The above-described embodiment of the present disclosure is an example of the present disclosure, and free modification is possible within the scope included in the spirit of the present disclosure. Accordingly, the present disclosure includes modifications of the present disclosure within the scope of the appended claims and the equivalents thereof.

## Claims

1. An X-ray detector with a driving sequence that repeats a standby section, a ready section, an integration section, and a readout section, the X-ray detector comprising:
a first electrode, on a substrate, to which a pixel voltage is applied;
a photoconductor layer on the first electrode; and
a second first electrode on the photoconductor layer,
wherein a switching voltage having a potential less than or equal to a potential of the pixel voltage is applied to the second electrode during at least a portion of the standby section, and a bias voltage is applied to the second electrode between the standby section and a next standby section.

2. The X-ray detector of claim 1, wherein during at least a portion of the standby section, the switching voltage having a same potential as the pixel voltage is applied to the second electrode.

3. The X-ray detector of claim 1, wherein during at least a portion of the standby section, the switching voltage having a potential lower than that of the pixel voltage is applied to the second electrode.

4. The X-ray detector of claim 1, wherein the standby section comprises a first period and a second period,
wherein during the first period, the switching voltage having a potential lower than that of the pixel voltage is applied to the second electrode, and
from the second period after the first period to the next standby section, the bias voltage is applied to the second electrode.

5. The X-ray detector of claim 1, wherein the standby section comprises a first period and a second period,
wherein during the first period, a first switching voltage is applied to the second electrode, and during the second period after the first period, a second switching voltage is applied to the second electrode,
wherein one of the first and second switching voltages has a same potential as the pixel voltage, and remaining one of the first and second switching voltages has a potential lower than that of the pixel voltage.

6. The X-ray detector of claim 1, wherein during the standby section, first and second switching voltages are alternately and repeatedly applied to the second electrode,
wherein one of the first and second switching voltages has a same potential as the pixel voltage, and remaining one of the first and second switching voltages has a potential lower than that of the pixel voltage.

7. The X-ray detector of claim 1, wherein the photoconductor layer is made of a ferroelectric material.

8. The X-ray detector of claim 7, wherein the ferroelectric material is perovskite.

9. The X-ray detector of claim 8, wherein a potential of the bias voltage is 0.01 to 0.1 V per thickness (µm) of the photoconductor layer (i.e., 0.01 to 0.1 V/µm).

10. The X-ray detector of claim 8, wherein a potential of the bias voltage is 1.5 to 20 V.
